(19)

Europäisches Patentamt

European Patent Office

Office européen des brevets

(11) EP 1 491 907 A1

(12) **EUROPEAN PATENT APPLICATION**

(43) Date of publication:
29.12.2004 Bulletin 2004/53

(51) Int Cl.⁷: **G01R 31/34**

(21) Application number: 04253723.3

(22) Date of filing: 22.06.2004

(84) Designated Contracting States:
**AT BE BG CH CY CZ DE DK EE ES FI FR GB GR HU IE IT LI LU MC NL PL PT RO SE SI SK TR**
Designated Extension States:
**AL HR LT LV MK**

(30) Priority: 23.06.2003 JP 2003177754

(71) Applicant: **FANUC LTD**
**Minamitsuru-gun, Yamanashi 401-0597 (JP)**

(72) Inventors:
• **Sakamoto, Keiji**
  **Hachioji-shi Tokyo 192-0033 (JP)**
• **Ota, Naoto**
  **Chiba 273-0045 (JP)**
• **Harada, Takashi**
  **Oshino-m,Minamitsuru-g**
  **Yamanashi401-0511 (JP)**
• **Yaeshima, Mamoru**
  **Kanagawa 257-0013 (JP)**

(74) Representative: **Billington, Lawrence Emlyn**
**Haseltine Lake,**
**Imperial House,**
**15-19 Kingsway**
**London WC2B 6UD (GB)**

(54) **Motor driving apparatus**

(57) A motor driving apparatus capable of predicting motor insulation deterioration at low costs. When a motor drive amplifier is not in operation, a relay contact K1 is turned on or closed to form a closed circuit of a motor housing grounded at G2, a motor coil, resistors R1, R2, the relay contact K1, diodes D4, D5, D6, an AC power source, and a ground point G1. A voltage of the AC power source to ground is applied to the closed circuit. When the insulation resistance of the motor is high, a small current flows through the closed circuit, so that potential difference across the resistor R1 is small. If the motor insulation is deteriorated, a leakage current increases. If potential difference across the resistor R1 exceeds a reference voltage determined by a Zener diode, an output signal is output from a comparator, a signal is output from a photocoupler, and the decrease in insulation resistance is indicated on an indicator of a control unit. The motor insulation deterioration is predicted with ease at low costs, thus preventing a sudden stop of operation caused by a leakage of current, etc.

FIG. 1

## Description

BACKGROUND OF THE INVENTION

1. Field of the Invention

The present invention relates to a motor driving apparatus capable of detecting motor insulation deterioration.

2. Description of Related Art

After long use, a motor entails insulation deterioration due to usage environment, etc. When a leakage current resulting from motor insulation deterioration operates an electric leakage breaker, an apparatus using a motor suddenly stops operating. Unclear in this case is whether the problem is in the motor or motor drive system, requiring long time to locate the cause of sudden stop. As a result, the apparatus using the motor, and the production line remain stopped for extended periods of time.

The aforementioned method of leakage current detection is generally used to determine motor insulation deterioration. A leakage current detectable by a leakage detector, a leakage protection relay, or the like is typically in the order of 15 mA, and a minimum detectable limit is about 3 mA. Thus, the motor insulation deterioration can be detected only after it has progressed.

As for air conditioner, there is proposed a method to find motor insulation deterioration in an air-conditioner compressor at an early stage to thereby prevent the air conditioner from being inoperable (JP-A-2001-141795). In this method, during motor shutdown, a series of high-frequency pulses are applied to one of transistors of a power converter for converting a DC voltage into an arbitrary voltage of an arbitrary frequency, thereby applying a high-frequency voltage to the motor. Then, a DC voltage obtained by rectifying and filtering three-phase AC power (or a preset voltage) and a motor current (a leakage current flowing through the motor applied with the high-frequency voltage) are detected. On the basis of the detected DC voltage and motor current, an insulation resistance is calculated, and an alarm is produced when the determined insulation resistance is less than a preset insulation resistance. There is proposed another method which calculates a motor insulation resistance and predicts insulation deterioration, while making a transistor conductive instead of applying high-frequency pulses thereto.

As mentioned above, the electric leakage detector can detect the motor insulation deterioration only after the deterioration has advanced. Moreover, when a sudden stop is caused by leakage, a determination must be made whether the cause of stop is in the motor or the motor drive device or other peripheral equipment, with the overall system including apparatus, production line, etc. stopped in operation. Besides, the leakage detector is not useful for prediction and preventive maintenance of motor insulation deterioration.

On the other hand, the method described in JP-A-2001-141795 is useful for prediction and preventive maintenance of motor insulation deterioration, but requires the detection of voltage and current. Furthermore, the current to be detected, while turning on one of transistors of a power converter, is a current on a current line that is used for motor current supply. Thus, even though the current to be detected is small, the detector must be designed by taking into account the presence of a large current, resulting in increased cost. When using a shunt resistor or a CT (current transformer) for the current detection, a problem is posed that the shunt resistor must be one that enables a large current to flow, and the CT becomes costly.

SUMMARY OF THE INVENTION

The present invention provides a motor driving apparatus capable of predicting motor insulation deterioration with low cost.

A motor driving apparatus of the present invention comprises: a motor driving unit for rectifying an alternating current from a grounded AC power source into a direct current and inverting the rectified direct current into an alternating current to drive the motor; a detection resistor connected in series with a coil of the motor; means for applying a DC voltage obtained by rectifying a voltage to ground of the AC power source to the coil of the motor through the detection resistor; and a voltage detection circuit for detecting a voltage between terminals of the detection resistor when the DC voltage is applied.

The motor driving apparatus may further comprise a comparator for comparing the voltage detected by the voltage detection circuit with a reference value and means for outputting an abnormality signal when the detected voltage exceeds the reference value.

Alternatively, the motor driving apparatus may further comprise an A/D-converter for A/D-converting the voltage detected by the voltage detection circuit, so that signals representing values of the AD-converted voltage are outputted for displaying the detected values on a display device, thereby the motor insulation deterioration is notified to an operator. In this case, the motor driving apparatus may further comprise a memory for storing values of the A/D-converted voltage, so that signals representing the values of the A/D-converted voltage stored in the memory are outputted to be displayed on the display device, thereby insulation deterioration history can be visually recognized by the operator.

An abnormality signal may be outputted when the voltage value AD-converted by the A/D-converter exceeds a reference value.

In this case, the motor driving apparatus may further comprise a memory storing reference values preset for specifications of different motors or motor driving units and a microprocessor connected with the A/D-converter and the memory, and the microprocessor may read a reference value for a specification of the motor or the motor driving unit in use from the memory, compare the value of the A/D-converted voltage with the read reference value and output an abnormality signal when the value of the A/D-converted voltage exceeds the read reference value.

Further, the motor driving apparatus may comprise means for detecting the voltage to ground of the AC power source, a memory storing reference values preset for voltages to ground of different AC power sources, and a microprocessor connected with the A/D-converter and the memory, wherein the microprocessor reads a reference value for the detected voltage to ground of the AC power source, compares the value of the A/D-converted voltage with the read reference value and outputs an abnormality signal when the A/D-converted value exceeds the read reference value.

The memory may store reference values preset for voltages to ground of different AC power sources and also specifications of different motors or motor driving units, and the microprocessor may read a reference value for the detected voltage to ground of the AC power source and a specification of the motor or the motor driving circuit in use, compare the A/D-converted value with the read reference value and output an abnormality signal when the A/D-converted value exceeds the read reference value.

The voltage detection circuit may have a switch for enabling and disabling the voltage detection, and the voltage detection is enabled by the switch when the motor is not driven by the motor driving unit, thereby allowing inspection of the insulation resistance deterioration.

BRIEF DESCRIPTION OF THE DRAWINGS

FIG. 1 is a block circuit diagram of essential part of a first embodiment of the present invention;
FIG. 2 is an equivalent circuit of a circuit for measuring a motor insulation resistance in the first embodiment;
FIG. 3 is a block circuit diagram of a motor insulation resistance detecting device used in a second embodiment of the present invention; and
FIG. 4 is a block circuit diagram of a motor insulation resistance detecting device used in a third embodiment of the present invention.

DETAILED DESCRIPTION

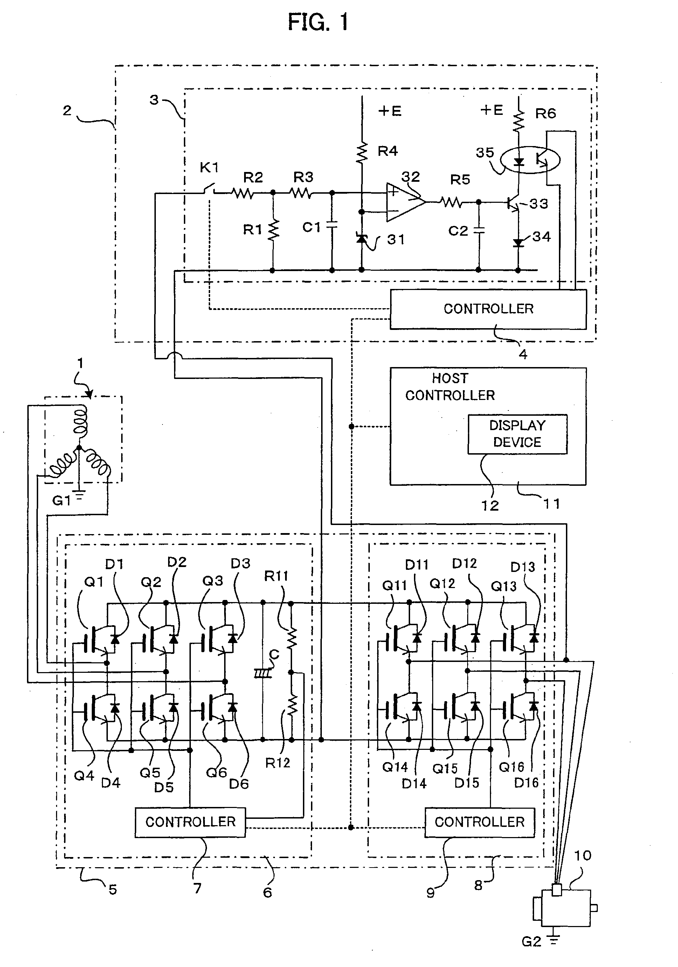

Referring to FIG. 1, a motor driving apparatus of a first embodiment of the present invention will be explained.

Reference numeral 1 denotes a grounded three-phase AC power source, and reference numeral 2 denotes a motor insulation resistance detecting device attached to the motor driving apparatus of the present invention, which is comprised of a voltage detection circuit 3 and a controller 4. Reference numeral 5 denotes a motor driving unit, which is comprised of a power section 6 including a rectifier circuit for converting three-phase AC power to DC power, and a motor drive amplifier 8 for converting the DC power to arbitrary AC power and driving a motor 10.

The power section 6 comprises the just-mentioned rectifier circuit that includes diodes D1-D6 for rectifying three-phase AC power to DC power, and switching elements Q1-Q6 constituted by IGBTs or the like for feeding regenerative currents back to the AC power in parallel to the diodes D1-D6, respectively. Further provided is a smoothing capacitor C for smoothing the rectified DC output obtained by the rectifier circuit constituted by the diodes D1-D6, and a voltage across the smoothing capacitor C is divided by resistors R11, R12. Based on the divided voltage, a controller 7 detects a regeneration start voltage, and on/off controls the switching elements Q1-Q6 thereby feeding the regenerative current back to the AC power source.

The motor drive amplifier 8 is constituted by a controller 9, and an inverter circuit that is comprised of switching elements Q11-Q16 formed by IGBTs or the like and diodes D11-16 connected in parallel to the switching elements Q11-Q16.

The controllers 7, 9 of the power section 6 and the motor drive amplifier 8 are connected with a host controller 11 of a numerical controller or the like for controlling the motor driving apparatus. Based on a command supplied from the host controller 11, the controller 9 on/off controls the switching elements Q11-Q16 to drivingly control the motor 10.

The above described construction of the motor driving unit 5 is the same as that of a known motor driving apparatus. The motor driving apparatus of the present invention is different in that it further comprises the motor insulation resistance detecting device 2 that is attached to the known motor driving apparatus.

The voltage detection circuit 3 of the motor insulation resistance detecting device 2 is connected to one phase line of connection lines that connect the inverter circuit of the motor drive amplifier 8 and coils of the motor 10, and to the negative side of a diode bridge of the power section 6, i.e., the anodes of the diodes D4, D5, and D6.

In the voltage detection circuit 3, K1 denotes a contact of a relay in the controller 4; R1-R6, resistors; C1 and C2, capacitors; 31, a Zener diode; 32, a comparator; 33, a transistor; 34, a diode; and 35, a photocoupler. Prior to the inverter circuit being operated in the motor drive amplifier 8 of the motor driving unit 5, the detection circuit 3 turns on or closes the relay contact K1, and measures the motor insulation resistance value based on the potential difference that is generated across the resistor R1 at that time.

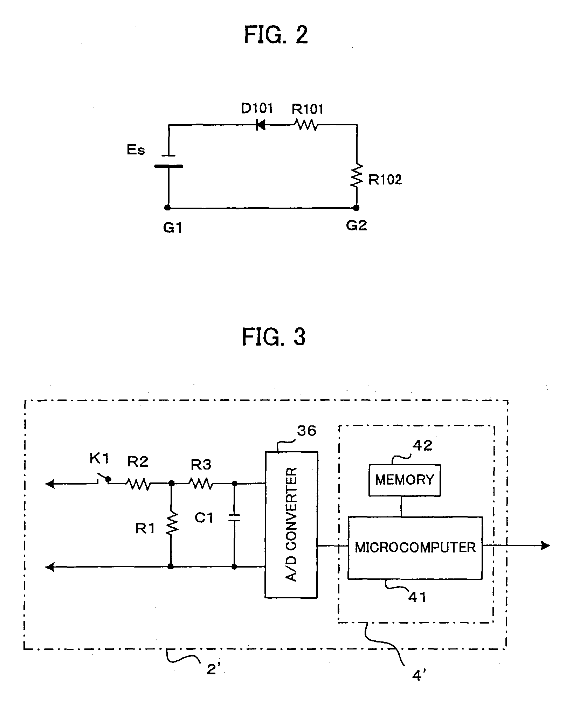

FIG. 2 shows an equivalent circuit of the aforesaid circuit for measuring the motor insulation resistance. In FIG. 2, Es represents the DC power obtained by rectifying the voltage of the grounded AC power source 1 to ground by the diodes D4, D5, and D6; D101 corresponds to the diodes D4, D5, and D6 shown in FIG. 1; R101 corresponds to the resistor R1; and R102 includes the resistor R2 but mainly represents the insulation resistance of the motor 10. This equivalent circuit is a closed circuit in which the housing of the motor 10 is grounded at G2 and which is formed by the insulation resistor R102, the motor coil, the connection line between the inverter circuit and the coil, the resistor R101 (R1), the closed relay contact K1, the diode D101 (D4, D5, D6), the voltage Es obtained by rectifying the voltage of the AC power source 1 to ground, and the ground point G1 that is connected to G2.

When the potential difference across the diode D101 (D4, D5, D6) is neglected, the potential difference V across the resistor R101 is represented by formula (1) which is as follows:

$$V = Es \times R101/(R101+R102) \qquad (1)$$

As apparent from formula (1), the potential difference V across the resistor R101 (the resistor R1 in FIG. 1) increases with the decreasing motor insulation resistance R102 to ground. Thus, a comparison is made between the potential difference V and a reference voltage, and the decrease in insulation resistance is notified, if the potential difference increases to equal to or higher than the reference voltage.

In the example shown in FIG. 1, the voltage across the resistor R1 is input to one of terminals of the comparator 32 through a filter for noise absorption that is comprised of the resistor R3 and the capacitor C1, whereas the reference voltage determined by the Zener diode 31 is input to another terminal of the comparator 32, whereby the potential difference across the resistor R1 and the reference voltage is compared. The output of the comparator 32 is input to the base of the transistor 33 through the filter formed by the resistor R5 and the capacitor C2. The diode 34 and the light emission element of the photocoupler 35 are connected in series with the transistor 33.

If the motor insulation resistance is deteriorated so that the insulation resistance R102 to ground lowers, the leakage current increases and the potential difference V across the resistor R1 increases. When the potential difference exceeds the reference voltage determined by the Zener diode 31, an output signal is output from the comparator 32 to turn on the transistor 33. As a result, an electric current flows through the light emission element of the photocoupler 35, and a signal is output from the photodetector thereof, which is then input to the controller 4 and transmitted to the host controller 11, so that the decrease in insulation resistance is indicated on a display device 12 of the host controller 11.

If the reference voltage determined by the Zener diode 31 is excessively low, the reference voltage is liable to be affected by surrounding noise or the like, and hence a reference voltage of 2 V to 3 V is ordinarily selected. In case that the AC power source 1 is in the form of a star connection with neutral ground and has a line voltage of 200 V, the voltage Es of the AC power source to ground is 200/1.732, and the peak voltage is (200/1.732)×1.414 = 163 V. If a leakage current in the order of 100 µA is detected using a reference voltage of 3 V, then an insulation resistance to ground of 1.6 MΩ can be detected, as understood from the relation of (163-3) V/100 µA = 1.6 MΩ.

On the contrary, a known leakage detector in which the detection current is not smaller than about 3 mA is only capable of detecting an insulation resistance to ground of not larger than 94.3 KΩ, as seen from the relation of 200×1.414 V/0.003 A = 94.3 KΩ.

As mentioned in the foregoing example, the known leakage detector cannot detect the insulation deterioration before the insulation resistance to ground decreases below 94.3 KΩ, whereas this embodiment can detect the insulation deterioration at an early stage when the insulation resistance to ground decreases to 1.6 MΩ.

Specifically, in response to an operation start command supplied from the host controller 11 to the motor driving unit 5, the power section 6 starts to operate. Thus, AC power is rectified by the diodes D1-D6 and the electrolytic capacitor C is charged. When it is determined based on the divided voltage at the resistors R11, R12 that the charging is completed, the motor drive amplifier 8 is started to be driven. Before the motor drive amplifier 8 is driven, electric power is supplied from the grounded AC power source to the motor driving apparatus. In this condition where the motor drive amplifier 8 is not in operation, the relay in the controller 4 of the motor insulation resistance detecting device 2 is actuated according to a command from the host controller 11, whereby the relay contact K1 is turned on or closed. As a result, the aforesaid circuit is formed by the ground point G2 at which the housing of the motor 10 is grounded, the motor insulation resistance, the motor coil, the connection line between the inverter circuit and the coil, the resistors R1, R2, the relay contact K1, the diodes D4, D5, D6, the AC power source 1, and the ground point G1. To this circuit, the voltage Es obtained by AD-converting the voltage of the AC power source to ground is applied.

When the potential difference generated across the resistor R1 by the electric current (leakage current) flowing through the just-mentioned circuit does not exceed the reference voltage determined by the Zener diode 31, no signal is output from the comparator 32. On the other hand, if the reference voltage is exceeded (i.e., if the insulation resistance of the motor 10 is deteriorated to decrease the insulation resistance to ground, and thus the leakage current increases), an output signal is output from the comparator 32 to turn on the transistor 33, so that an electric current flows through the light emission element of the photocoupler 35 from which an output signal is then supplied though the controller 4 to the host controller 11, whereby the decrease in insulation resistance to ground is indicated by the display device 12 of the host controller 11. Looking at this indication, an operator shuts down the power of the motor driving apparatus and makes motor replacement or the like, where required.

As explained above, under the condition that the motor drive amplifier 8 is not driven but the motor driving unit 5 is supplied with AC power, the processing of detecting the decrease in motor insulation resistance to ground or maintenance management is performed by actuating the relay, whereby the preventive maintenance of motor insulation deterioration can be achieved.

Meanwhile, when the motor drive amplifier 8 is driven to thereby operate the motor 10, the relay contact K1 is maintained turned off or open.

FIG. 3 is a block circuit diagram of a motor insulation resistance detecting device 2' used in a second embodiment of the present invention. In the foregoing first embodiment, the indication of insulation deterioration is given only when the potential difference across the resistor R1 exceeds the reference voltage determined by the Zener diode 31, i.e., only when the insulation resistance to ground decreases to or below a predetermined value. On the other hand, the second embodiment is arranged to detect motor insulation deterioration using the motor insulation resistance detecting device 2' shown in FIG. 3 instead of the detecting device 2 used in the first embodiment. Another feature is to detect the insulation deterioration according to a motor drive amplifier specification (type) of the motor driving unit 5 or a motor specification (type).

A detection circuit is comprised of the same relay contact K1, resistors R1, R2, R3 and capacitor C1 as those of the first embodiment, but differs from the first embodiment in that the voltage across the resistor R1 is supplied to an A/D converter (for converting an analog signal to a digital signal) 36. Furthermore, the second embodiment differs from the first embodiment in that it comprises a controller 4' comprised of a microcomputer 41 and a memory 42.

In the memory 42, reference values used for indication of motor insulation deterioration are stored in advance that individually correspond to specifications (types) of motor drive amplifiers 8 adapted to be mounted to the motor driving unit 5 or motor specifications (types). The motor drive amplifier 8 includes a controller 9 that is provided with a memory in which the specification (type) of the motor drive amplifier 8 or the specification (type) of the motor is stored.

To detect the insulation resistance to ground, AC power is supplied to the motor driving unit 5, as mentioned above. Subsequently, in a condition that the motor drive amplifier 8 is in an inoperative state, a command for detection of insulation resistance to ground is supplied to the host controller 11. In response to this, the host controller 11 reads the specification (type) of the motor drive amplifier from the controller 9 of the motor drive amplifier 8, and transmits the same to the controller 4' of the motor insulation resistance detecting device 2', and also transmits a command for detection of insulation resistance to ground. The controller 4' responds to this detection command to actuate the relay so as to close the relay contact K1, and a potential difference across the resistor R1 is converted into a digital signal in the A/D converter 36. The microcomputer 41 reads the detected potential difference and writes the same into the memory 42. Further, the reference value corresponding to the specification (type) of the motor drive amplifier or the specification (type) of the motor is read from the memory 42 which is then compared with the detected potential difference. If the detected potential difference exceeds the reference value, a signal indicating the decrease in insulation resistance to ground is transmitted to the host controller 11. When receiving the signal, the host controller 11 causes the display device 12 to indicate the decrease in insulation resistance to ground, and transmits the motor driving unit 5 with a signal to disable its operation.

In accordance with the command supplied from the host controller 11, the microprocessor 41 transmits all the data of potential differences detected and stored in the memory or transmits data individually obtained at the current and preceding inspections to the host controller 11, so as to indicate these data. Thus, a history of insulation resistance to ground is indicated, whereby the status of progress of insulation deterioration is notified.

In a case where a plurality of motor drive amplifiers 8 are connected to the power section 6 of the motor driving unit 5, the detection circuit (comprised of the relay contact K1, resistors R1, R2, R3, capacitor C1, and A/D converter) may be provided for every motor drive amplifier 8 in the motor insulation resistance detecting device 2'. Insulation resistances of the respective motor drive amplifiers to ground or insulation resistances of the respective motors to ground are detected, and their histories are stored. The measured insulation resistances are compared with reference values for the type of the respective motor drive amplifiers (types of the respective motors), respectively, whereby insulation deterioration can be indicated, if any.

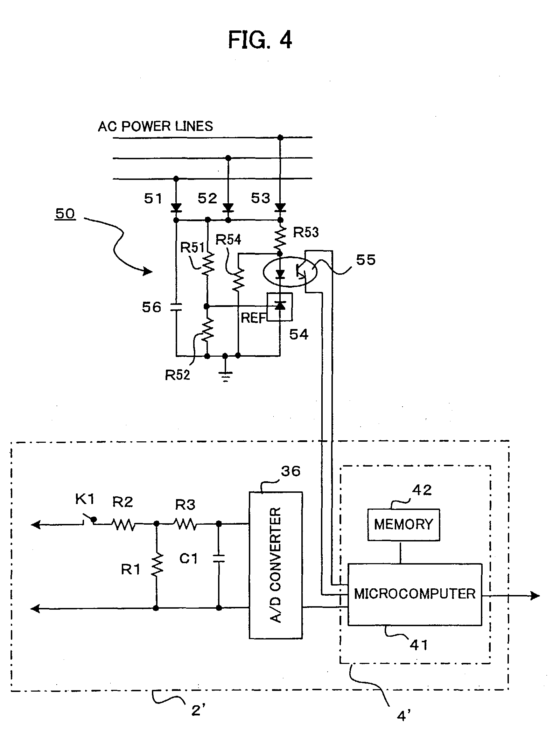

FIG. 4 is a block circuit diagram showing essential part of a third embodiment of the present invention. In the foregoing first and second embodiments, it is assumed that one or more grounded AC power sources are of a certain predetermined type. On the other hand, even if the line voltage (power source voltage) is the same, the voltage Es to ground varies depending on whether the connection of the AC power source is a star connection or a delta connection. By way of example, in case that the line voltage (power source voltage) is 200 V, the voltage to ground is AC 115 V for star connection and AC 200 V for delta connection. In the case of 400 V line voltage (power source voltage), the voltage to ground is AC 230 V for star connection. Ordinarily, no delta connection is available for 400 V line voltage (power source voltage).

As explained above, the voltage Es to ground is different between star connection and delta connection. For different voltages Es to ground, the potential difference across the resistor R1 in the detection circuit of each motor insulation resistance detecting device 2 or 2' varies naturally. This requires that the reference value used to determine the deterioration of insulation resistance to ground be varied.

Therefore, the third embodiment is configured to also determine a connection type of the AC power source, and in accordance with the type of motor drive amplifier (motor type), select the reference value for determining the deterioration of insulation resistance to ground, thus determining insulation deterioration.

The third embodiment differs from the second embodiment in that it comprises a line-to-ground voltage detection circuit 50 for detecting the voltage Es of the AC power source 1 to ground, and for generating an output, which is supplied to the microcomputer 41 in the controller of the motor insulation resistance detecting device 2' described in the second embodiment.

The line-to-ground voltage detection circuit 50 is comprised of diodes 51, 52, 53 individually connected to AC power lines of the grounded AC power source 1 (AC power lines extending between the AC power source 1 and the power section 6 of the motor driving unit 5), a capacitor 56, resistors R51, R52, R53, R54, a shunt regulator 54, and a photocoupler 55 whose output is connected to the microcomputer 41.

The voltage of the AC power source 1 to ground is rectified by the diodes 51, 52, 53 and is noise-reduced by the capacitor 56. The resultant voltage is divided by the resistors R51, R52, and the divided voltage is supplied as a voltage $V_{REF}$ to a terminal of the shunt regulator 54. When the voltage $V_{REF}$ exceeds the reference voltage that is preset in the shunt regulator 54, this regulator 54 is made conductive, so that an electric current flows through the light emission element of the photocoupler 55 from which an output signal is output.

In the case of the AC power source 1 of 200 V, the voltage to ground is 115 V for star connection and 200 V for delta connection. Thus, the reference voltage in the shunt regulator 54 is set in such a manner that, when the voltage rectified by the diodes 51-53 is, e.g., at 185 V or more between 115 V and 200 V, the reference voltage is exceeded by the divided voltage $V_{REF}$. By doing this, if the AC power source 1 is delta-connected, the shunt regulator 54 is rendered conductive, and hence the photocoupler 55 outputs an output signal to the microcomputer 41 which can therefore determine that the AC power source is delta-connected. In other words, by determining whether or not an output signal is delivered from the photocoupler 55, the microcomputer 41 can determine whether the AC power source 1 is star-connected (absence of signal) or delta-connected (presence of signal).

To this end, reference values for use in determining the deterioration of insulation resistance to ground are set and stored according to the specifications (types) of the motor drive amplifier or the specifications (types) of the motor and according to the presence and absence of output signal from the photocoupler 55. In accordance with the presence or absence of the output signal from the photocoupler 55 and the type of the motor drive amplifier, the microcomputer 41 selects an appropriate one of the reference values stored in the memory, and compares the selected reference value and an output value of the A/D converter 36. When the output value from the A/D converter 36 exceeds the reference value, a signal for indicating insulation deterioration is given to the display device 12 of the host controller 11.

As for the function of determining whether the grounded AC power source is start-connected or delta-connected achieved by the ground voltage detection circuit 50, the voltage to ground to be detected considerably differs between the star connection and the delta connection. Thus, instead of using the ground voltage detection circuit 50, such function can be achieved by using comparator circuits or the like for comparing the voltage with reference values, or by using relays or the like.

The present invention can predict the deterioration of motor insulation resistance by attaching a motor insulation resistance detecting device, which is simple in construction, to a motor driving apparatus. This makes it possible to prevent a system such as apparatus, production line, etc. using one or more motors from being suddenly stopped in operation, which would otherwise be caused by a leakage of current due to motor insulation deterioration. Thus, maintenance management and preventive maintenance can be made with ease, and operation efficiency can also be improved.

**Claims**

1. A motor driving apparatus for driving a motor using a grounded AC power source, comprising:

   a motor driving unit for rectifying an alternating current from the grounded AC power source into a direct current and inverting the rectified direct current into an alternating current to drive the motor;
   a detection resistor connected in series with a coil of the motor;

means for applying a DC voltage obtained by rectifying a voltage to ground of the AC power source to the coil of the motor through said detection resistor; and
a voltage detection circuit for detecting a voltage between terminals of said detection resistor when the DC voltage is applied.

2. A motor driving apparatus according to claim 1, further comprising a comparator for comparing the voltage detected by said voltage detection circuit with a reference value and means for outputting an abnormality signal when the detected voltage exceeds the reference value.

3. A motor driving apparatus according to claim 1, further comprising an A/D-converter for A/D-converting the voltage detected by said voltage detection circuit, wherein signals representing values of the AD-converted voltage are outputted to be displayed on a display device.

4. A motor driving apparatus according to claim 3, further comprising a memory for storing values of the A/D-converted voltage, wherein signals representing the values of the A/D-converted voltage stored in said memory are outputted to be displayed on the display device.

5. A motor driving apparatus according to claim 1, further comprising an A/D-converter for A/D-converting the voltage detected by said voltage detection circuit, wherein an abnormality signal is outputted when the AD-converted voltage exceeds a reference value.

6. A motor driving apparatus according to claim 5, further comprising a memory storing reference values preset for specifications of different motors or motor driving units and a microprocessor connected with said A/D-converter and said memory, wherein said microprocessor reads a reference value for a specification of the motor or the motor driving unit in use from said memory, compares the value of the A/D-converted voltage with the read reference value and outputs an abnormality signal when the value of the A/D-converted voltage exceeds the read reference value.

7. A motor driving apparatus according to claim 5, further comprising means for detecting the voltage to ground of the AC power source, a memory storing reference values preset for voltages to ground of different AC power sources, and a microprocessor connected with said A/D-converter and said memory, wherein said microprocessor reads a reference value for the detected voltage to ground of the AC power source, compares the value of the A/D-converted voltage with the read reference value and outputs an abnormality signal when the A/D-converted value exceeds the read reference value.

8. A motor driving apparatus according to claim 5, further comprising means for detecting the voltage to ground of the AC power source, a memory storing reference values preset for voltages to ground of different AC power sources and specifications of different motors or motor driving units, and a microprocessor connected with said A/D-converter and said memory, wherein said microprocessor reads a reference value for the detected voltage to ground of the AC power source and a specification of the motor or the motor driving circuit in use, compares the A/D-converted value with the read reference value and outputs an abnormality signal when the A/D-converted value exceeds the read reference value.

9. A motor driving apparatus according to claim 1, wherein said voltage detection circuit has a switch for enabling and disabling the voltage detection, and the voltage detection is enabled by said switch when the motor is not driven by the motor driving unit.

10. A method for driving a motor using a grounded AC power source, comprising steps of:

rectifying an alternating current from the grounded AC power source into a direct current and inverting the rectified direct current into an alternating current to drive the motor;
applying a DC voltage obtained by rectifying a voltage to ground of the AC power source to a coil of the motor through a detection resistor; and
detecting a voltage between terminals of the detection resistor when the DC voltage is applied.

# FIG. 1

## FIG. 2

## FIG. 3

# FIG. 4

AC POWER LINES

European Patent Office

## EUROPEAN SEARCH REPORT

Application Number

EP 04 25 3723

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 0 780 960 A (MITSUBISHI ELECTRIC CORP) 25 June 1997 (1997-06-25) * abstract; figures 4,5,9 * * column 2, line 12 - column 3, line 6 * * column 3, line 41 - column 4, line 12 * * column 5, line 19 - line 23 * * column 12, line 3 - line 50 * ----- | 1-10 | G01R31/34 |
| X | US 5 963 410 A (IIJIMA YASUO ET AL) 5 October 1999 (1999-10-05) * abstract; claims 1,3; figure 1 * * column 2, line 48 - column 3, line 13 * * column 3, line 53 - column 4, line 4 * * column 4, line 40 - line 52 * * column 5, line 7 - line 27 * ----- | 1-10 | |
| | | | **TECHNICAL FIELDS SEARCHED** (Int.Cl.7) G01R |

The present search report has been drawn up for all claims

| Place of search | Date of completion of the search | Examiner |
|---|---|---|
| Berlin | 23 September 2004 | Binger, B |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                    EP 04 25 3723

This annex lists the patent family members relating to the patent documents cited in the above-mentioned European search report.
The members are as contained in the European Patent Office EDP file on
The European Patent Office is in no way liable for these particulars which are merely given for the purpose of information.

23-09-2004

| Patent document cited in search report | | Publication date | Patent family member(s) | | Publication date |
|---|---|---|---|---|---|
| EP 0780960 | A | 25-06-1997 | JP | 3331881 B2 | 07-10-2002 |
| | | | JP | 9233837 A | 05-09-1997 |
| | | | CN | 1159675 A ,B | 17-09-1997 |
| | | | DE | 69611977 D1 | 12-04-2001 |
| | | | DE | 69611977 T2 | 04-10-2001 |
| | | | EP | 0780960 A1 | 25-06-1997 |
| | | | HK | 1002794 A1 | 13-07-2001 |
| | | | JP | 2002272132 A | 20-09-2002 |
| | | | KR | 274292 B1 | 15-12-2000 |
| | | | US | 5748459 A | 05-05-1998 |
| US 5963410 | A | 05-10-1999 | JP | 9043302 A | 14-02-1997 |

For more details about this annex : see Official Journal of the European Patent Office, No. 12/82